# EUROPÄISCHE PATENTSCHRIFT

(11) **EP 1 747 706 B1**
(45) Veröffentlichungstag und Bekanntmachung des Hinweises auf die Patenterteilung: **25.03.2009**
(21) Anmeldenummer: 05749703.4
(22) Anmeldetag: 17.05.2005
(51) Int. Cl.: H05K 13/00

(54) **TRÄGER MIT LOTKUGELELEMENTEN UND EIN VERFAHREN ZUM BESTÜCKEN VON SUBSTRATEN MIT KUGELKONTAKTEN**
SUPPORT WITH SOLDER GLOBULE ELEMENTS AND A METHOD FOR ASSEMBLY OF SUBSTRATES WITH GLOBULE CONTACTS
SUPPORT A ELEMENTS SPHERIQUES A BRASER ET PROCEDE POUR EQUIPER DES SUBSTRATS DE CONTACTS SPHERIQUES

(30) Priorität: 19.05.2004 DE 102004025279
(43) Veröffentlichungstag der Anmeldung: 31.01.2007
(73) Patentinhaber: Infineon Technologies AG, 81669 München (DE)
(72) Erfinder: BAUER, Michael, 93152 Nittendorf (DE); BEMMERL, Thomas, 92421 Schwandorf (DE); FÜRGUT, Edward, 86453 Dasing (DE); JEREBIC, Simon, 93049 Regensburg (DE); VILSMEIER, Hermann, 93059 Regensburg (DE)
(74) Vertreter: Schäfer, Horst
(86) Internationale Anmeldenummer: PCT/DE2005/000892
(87) Internationale Veröffentlichungsnummer: WO 2005/115072

(56) Entgegenhaltungen:
- EP-A- 0 840 368
- EP-A- 0 955 676
- US-A- 6 071 801
- US-A- 6 080 650
- US-B1- 6 239 013
- US-B1- 6 303 407

## Beschreibung

Die Erfindung betrifft eine Anlage sowie ein Verfahren für ein Bestücken von Substraten mit Kugelkontakten. In diesem Zusammenhang werden unter dem Ausdruck Substrat die Komponenten in einer Halbleiterfertigung verstanden, auf die in einem vorbestimmten Anordnungsmuster Lotkugelelemente aufzubringen sind, wie Halbleiterwafer mit vielen Halbleiterchippositionen, einzelne Halbleiterchips, Zwischenverdrahtungsplatten von Halbleiterstapelbauteilen, Verdrahtungsplatten von einzelnen Halbleiterbauteilen und/oder Leiterplatten von einem Nutzen, der eine Vielzahl von Halbleiterbauteilpositionen aufweisen kann.

Unter dem Begriff Kugelkontakte werden Kontakte, wie äußerst kleine Flipchip-Kontakte mit Außenabmessungen von einigen Mikrometern verstanden, bis hin zu Kontakten, wie den Zwischenkontakten in Halbleiterbauteilstapeln mit Außenabmessungen im Millimeterbereich. Während die Flipchip-Kontakte auf Kontaktflächen von beispielsweise 42 x 42 µm² (Quadratmikrometer) eines Halbleiterwafers oder eines Halbleiterchips positioniert werden, überbrücken die Zwischenkontakte den Abstand zwischen Unterseite und Oberseite eines Halbleitergehäuses in einem Halbleiterstapelbauteil und können Außenmaße von einigen Millimetern erreichen. Zwischen diesen beiden extremen Außenabmessungen liegen die Außenabmessungen der Außenkontakte für Halbleiterbauteile mit BGA (ball grid array)-Gehäusen, die heute weit verbreitet sind.

Dennoch ist das Bestücken eines Substrats mit derartigen Kugelkontakten schwierig, wobei der Schwierigkeitsgrad bei einer konkreten Montage und damit der Ausschuss mit kleiner werdenden Abmessungen zunimmt, zumal auch die Anzahl der aufzubringenden Kugelkontakte steigt. Die bisher praktizierten Bestückungsmethoden sind aufwendig und kostenintensiv. Eine derartige Methode sieht vor, dass die Lotkugelelemente für Kugelkontakte in Vertiefungen einer Matrize eingerüttelt werden und sobald alle Vertiefungen eines vorgegebenen Anordnungsmusters mit Lotkugelelementen gefüllt sind, können die Lotkugelelemente in den Vertiefungen der Matrize mit einem entsprechenden Muster von Kontaktflächen auf dem Substrat, beispielsweise durch gleichzeitiges gemeinsames Auflöten, verbunden werden. Diese Technik ist besonders problematisch, wenn ein ganzer Halbleiterwafer mit Lotkugelelementen versehen werden soll, zumal die Anzahl der gleichzeitig aufzubringenden Lotkugelelemente in die Tausende geht.

Aus der US 6,303,407 ist ein Verfahren bekannt, bei dem Lotkugel auf haftenden Bereichen eines Trägers aufgebracht wird. Die Anordnung der haftenden Bereiche entspricht der Anordnung der Kontaktflächen, auf die die Lotkugel aufgebracht werden sollen.

Aufgabe der Erfindung ist es, ein Verfahren sowie eine Anlage für ein Bestücken von Substraten mit Lotkugelelementen anzugeben, das die Schwierigkeiten der bekannten Verfahren überwindet, eine erhöhte Zuverlässigkeit des Bestückens von Substraten mit Lotkugelelementen ermöglicht und einen Träger mit Lotkugelelementen schafft, der ein frei wählbares Anordnungsmuster möglich macht. Ein Träger mit Lotkugelelementen zur Verwendung bei dem Verfahren und der Anlage soll im Gegensatz zu Matrizen mit Vertiefungen kostengünstig herstellbar sein und einen schnellen Designwechsel im Anordnungsmuster für Lotkugelelemente für unterschiedliche Anordnungsmuster von Kontaktflächen auf Substraten ermöglichen.

Gelöst wird diese Aufgabe mit dem Gegenstand der unabhängigen Ansprüche. Vorteilhafte Weiterbildungen der Erfindung ergeben sich aus den abhängigen Ansprüchen.

Ein Träger mit Lotkugelelementen wird für ein Bestücken von Substraten mit Kugelkontakten angegeben. Dieser Träger weist eine einseitig aufgebrachte Klebstoffschicht auf. Die Klebstoffschicht besteht aus einem Thermoplast oder Duroplast, dessen Adhäsionskraft bei Bestrahlung vermindert ist. Ferner weist der Träger Lotkugelelemente auf, die dicht gepackt in Zeilen und Spalten auf der Klebstoffschicht angeordnet sind. Diese dichte Packung weist in den Zeilen und Spalten die Lotelemente in vorgegebener minimal zulässiger Schrittweite für einen Halbleiterchip oder ein Halbleiterbauteil auf.

Ein Vorteil dieses Trägers mit Lotkugelelementen ist es, dass er mit minimal zulässiger Schrittweite für sämtliche Positionen, die auf einem Halbleiterchip oder einem Halbleiterbauteil möglich sind, Kugelelemente anbietet. Ferner ist es ein Vorteil dieses Trägers, der diese dicht gepackten Lotkugelelemente aufweist, dass die Adhäsionskraft der Klebstoffschicht bei Bestrahlung vermindert ist. Somit kann durch gezielte Bestrahlung einzelner Positionen von Lotkugelelementen das dort befindliche Lotkugelelement an seiner Position gelockert oder sogar zum Abfallen gebracht werden. Selbst ein Lockern der Lotkugelelemente reicht aus, um die gelockerten Lotkugelelemente mit einfachem Schütteln oder mit anderen Hilfsmitteln aus ihren Positionen zu entfernen, und mit den verbleibenden Lotkugelelementen ein Anordnungsmuster zu erhalten, das genau dort Lotkugelelemente aufweist, wo entsprechende Kontaktflächen eines Substrats angeordnet sind. Durch Vorhalten von Trägern mit dicht.gepackten Lotkugelelementzeilen und -spalten aber mit unterschiedlicher minimaler Schrittweite, kann in vorteilhafter Weise ein Vorrat an Trägern für die unterschiedlichsten Anwendungsformen vorgehalten werden.

In einer bevorzugten Ausbildung des Trägers ist dieser auf ein zu bestückendes Substrat in Form eines Halbleiterwafers angepasst. Dabei weist der Träger ein Anordnungsmuster für Flipchip-Kontakte für eine Vielzahl von Halbleiterchips auf dem Halbleiterwafer auf. In allen Lotkugelpositionen des dafür vorgesehenen Trägers werden diejenigen Lotkugelelemente durch Bestrahlen der Klebstoffschicht gelockert und entfernt, für die auf dem Halbleiterwafer keine Kontaktfläche vorgesehen ist.

In einer weiteren Ausführungsform ist der Träger an das Anordnungsmuster für Flipchip-Kontakte eines Halbleiterchips angepasst, so dass Halbleiterchips in rationeller Weise mit Flipchip-Kontakten ausgestattet werden können. Auch hier kann ein dann standardisierter Träger mit einer standardisierten Schrittweite für die Lotkugelelemente eingesetzt werden, der je nach Bedarf an Kugelkontakten für den Halbleiterchip durch Bestrahlen einzelner Lotkugelelementpositionen modifiziert werden kann.

Bei einer weiteren Ausführungsform ist es vorgesehen, dass eine Leiterplatte eines Nutzens als zu bestückendes Substrat bereitgestellt wird. Dazu weist der Träger ein Anordnungsmuster für Kugelkontakte einer Vielzahl von Halbleiterbauteilen des Nutzens auf. Diese Ausführungsform hat den Vorteil, dass für einen Nutzen gleichzeitig sämtliche benötigten Außenkontakte der Halbleiterbauteile auf den Nutzen gemeinsam mit einem Verfahrensschritt aufgebracht werden können.

Weiterhin ist es vorgesehen, dass das zu bestückende Substrat ein Verdrahtungsträger eines Halbleiterbauteils ist. In diesem Fall weist der Träger ein Anordnungsmuster für Außenkontakte eines Halbleiterbauteils auf. Derartige Außenkontakte eines Halbleiterbauteils sind größer als Flipchip-Kontakte eines Halbleiterchips. Dementsprechend ist auch die minimale Schrittweite, in der die Lotkugelelemente auf dem Träger angeordnet sind, größer.

Schließlich ist es vorgesehen, als zu bestückendes Substrat eine Zwischenverdrahtungsplatte mit entsprechenden Stapelkontakten auszustatten. Derartige Stapelkontakte weisen Außenabmessungen auf, die der Dicke eines der zu stapelnden Halbleiterbauteile entsprechen und stellen an der Oberseite und der Unterseite eines Halbleiterbauteils jeweils eine metallische Außenkontaktfläche zur Verfügung, so dass von oben nach unten, beziehungsweise von unten nach oben ein Durchkontaktieren durch den Halbleiterstapel über die Stapelkontakte möglich wird. Dazu weisen die Stapelkontakte Außenabmessungen auf, die größer sind als die Dicke eines Halbleiterchips und die Außenmaße einer Dicke eines Halbleiterbauteils erreichen können.

Ein Aspekt der Erfindung betrifft eine Anlage für ein Bestücken von Substraten mit Kugelkontakten. Diese Anlage weist einen Träger mit einseitiger Klebstoffschicht auf, wobei die Klebstoffschicht einen Thermoplast oder Duroplast darstellt, dessen Adhäsionskraft bei Bestrahlung vermindert ist. Ferner weist die Anlage Kugelelemente auf, die dicht gepackt in Zeilen und spalten auf der Klebstoffschicht in vorgegebenen minimal zulässigen Schrittweiten für einen Halbleiterchip oder ein Halbleiterbauteil angeordnet sind.

Neben dem Träger mit den Lotkugelelementen weist die Anlage eine Bestrahlungseinrichtung mit einer Strahlungsquelle auf. Schließlich verfügt die Anlage über eine Abnahmeeinrichtung zum Entnehmen der gelockerten Lotkugelelemente unter Zurücklassung von Lotkugelelementen in einem Anordnungsmuster für Flipchip-Kontakte oder Kugelkontakte. Diese Abnahmeeinrichtung zum Entfernen der gelockerten Lotkugelelemente kann auf verschiedene bevorzugte Weise ausgebildet sein, wie es nachfolgend noch näher beschrieben wird.

Neben der Abnahmeeinrichtung zum Entfernen gelockerter Lotkugelelemente umfasst die Anlage eine Bestückungseinrichtung zum Fixieren der in einem vorgegebenen Anordnungsmuster auf dem Träger verbliebenen Lotkugelelemente auf entsprechende Kontaktflächen des Halbleiterwafers oder des Halbleiterchips oder eines Verdrahtungsträgers für ein Halbleiterbauteil. Darüber hinaus besitzt die Anlage eine Abzugseinrichtung zum Abziehen des Trägers von den Kugelkontakten, sobald diese in der Bestückungseinrichtung mit den Kontaktflächen der Substrate verbunden sind.

Diese Anlage hat den Vorteil, dass sie nur wenige Komponenten aufweisen muss, um relativ komplexe Kontaktanordnungsmuster auf entsprechenden Substraten zu realisieren. Darüber hinaus hat die Anlage den Vorteil, dass sie äußerst kostengünstig zur Verfügung gestellt werden kann. Und schließlich hat die Anlage den Vorteil, dass sie auch in Untergruppen gegliedert werden kann, wobei eine der Untergruppen lediglich die Standardträger mit dichtgepackten Lotkugelelementen herstellt. Eine andere Komponente übernimmt das Strukturieren zu einem Anordnungsmuster, und erst in einer weiteren Komponente wird das Substrat mit dem Träger zum Bestücken mit Lotkugelelementen zusammengeführt.

In einer bevorzugten Ausführungsform der Erfindung weist die Bestrahlungseinrichtung eine Laserstrahlquelle auf. Mit Hilfe entsprechender Ablenkvorrichtungen kann die Laserstrahlquelle durch Scannen des Laserstrahls ein selektives Bestrahlen des Trägers an vorgesehenen Positionen ausführen. Eine derartige Verfahrensvariante hat den Vorteil, dass für eine selektive Bestrahlung des Trägers keine Masken vorzusehen sind, sondern lediglich das Scannen des Lasers entsprechend zu programmieren ist. Somit werden an allen belichteten Positionen die Lotkugelelemente des Trägers gelockert und an den Positionen, an denen die Lotkugelelemente für ein Anordnungsmuster von Kugelkontakten auf entsprechenden Substraten erforderlich ist, wird ein Bestrahlen des Lasers unterdrückt.

Bei einer weiteren Ausführungsform der Anlage weist die Bestrahlungseinrichtung eine UV-Quelle auf. Diese UV-Quelle bestrahlt flächig den Träger, so dass die Anlage zusätzlich einen Maskenhalter aufweist, der zwischen UV-Quelle und Träger für ein selektives Bestrahlen des Trägers an vorgesehenen Positionen vorgesehen ist. Dieser Maskenhalter weist Masken auf, die nur an den Positionen UV-Strahlen auf den Träger und damit auf die Klebeschicht zulassen, an denen Lotkugelelemente zu lockern beziehungsweise zu entfernen sind.

Weiterhin ist es vorgesehen, dass die Anlage eine Abnahmeeinrichtung zum Entfernen der gelockerten Lotkugelelemente besitzt, die in einer bevorzugten Ausführungsform der Erfindung eine Walze oder ein Endlosband aufweist. Diese Walze oder dieses Endlosband sind mit einer klebrigen Oberfläche versehen, so dass die zu entfernenden, gelockerten Lotkugelelemente auf der klebrigen Oberfläche haften bleiben. Diese Abnahmevorrichtung hat den Vorteil, dass die durch Bestrahlung der Klebstelle gelockerten Lotkugelelemente relativ schonend abgenommen und sicher abtransportiert werden können, da sie auf den klebrigen Oberflächen des Endlosbandes beziehungsweise der Walze hängen bleiben.

In einer weiteren Ausführungsform der Anlage ist es vorgesehen, dass die Abnahmeeinrichtung zum Entfernen der gelockerten Lotkugelelemente eine Walze oder ein Endlosband aufweist, auf deren Oberseiten Abstreifborsten vorgesehen sind. Mit derartigen Abstreifborsten werden die gelockerten Lotkugelelemente zwar entfernt, jedoch kann es vorkommen, dass bei dem Abstreifvorgang Lotkugeln in die Anlage springen und den Betrieb behindern können. Insofern weist die Abnahmevorrichtung zusätzlich einen die Abstreifeinrichtung umgebenden Behälter auf, der sämtliche durch die Abstreifborsten gelösten Lotkugelelemente auffängt und sammelt. Die aufgefangenen Kugeln können dann wieder für ein Bestücken eines Trägers mit dichtgepackter Lotkugelelementanordnung eingesetzt werden.

Neben einer möglichen Halterung für Masken sowie Halterungen für die Abnahmeeinrichtung und Bestrahlungseinrichtung weist die Bestückungseinrichtung zusätzlich eine Halterung für die zu bestückenden Substrate auf. Darüber hinaus weist die Anlage eine Trägerhalterung für den Träger mit einem Anordnungsmuster aus Lotkugelelementen auf. Beide werden in der Bestückungseinrichtung mit Hilfe von Justagemitteln so ausgerichtet, dass die verbliebenen Lotkugelelemente des Trägers in der Trägerhalterung auf Kontaktflächen der zu bestückenden Substrate in der Substrathalterung ausgerichtet werden'können. Erst nach Ausrichten von Träger und Substrat werden beide zusammengeführt und in einem Temperaturschritt können die Lotkugelelemente auf das Substrat an vorgesehenen und ausgerichteten Positionen aufgelötet werden.

Ein Verfahren für ein Bestücken von Substraten mit Kugelkontakten weist die nachfolgenden Verfahrensschritte auf. Zunächst wird aus einem Trägermaterial ein Band mit einseitiger Klebstoffschicht, die einen Thermoplast oder Duroplast, dessen Adhäsionskraft bei Bestrahlung vermindert ist, hergestellt. Auf diesem Band werden anschließend auf der Klebstoffschicht Lotkugelelemente in Zeilen und Spalten in vorgegebener minimal zulässiger Schrittweite für einen Halbleiterchip oder für ein Halbleiterbauteil angeordnet.

Dieses mit Lotkugelelementen dicht bepackte Trägerband wird anschließend selektiv zur Minderung der Adhäsion der Klebstoffschicht und zur Lockerung von Lotkugelelementen an vorgesehenen Positionen bestrahlt. Anschließend werden die gelockerten Lotkugelelemente unter Zurücklassung von auf dem Träger fixierten Lotkugelelementen in einem Anordnungsmuster für einen Halbleiterchip oder für ein Halbleiterbauteil entfernt. Nach einer Justage des so vorbereiteten Trägers mit Lotkugelelementen an vorbestimmten Positionen, wird dieser gegenüber einem Substrat mit Kontaktflächen für das Aufbringen von Lotkugelelementen und Auflöten zu Kugelkontakten ausgerichtet. Anschließend erfolgt ein Auflöten der in einem vorgegebenen Anordnungsmuster auf dem Träger verbliebenen Lotkugelelemente auf Kontaktflächen eines Halbleiterwafers oder Halbleiterchips oder auf einen Verdrahtungsträgers für Halbleiterbauteile. Auch großvolumige Lotkugelelemente für Zwischenkontakte eines Halbleiterstapelbauteils können auf diese Weise vorbereitet und an den entsprechenden Positionen aufgelötet werden.

Nach dem Auflöten erfolgt das Abziehen des Trägers von dem mit Flipchip-Kontakten oder mit Kugelkontakten bestückten Substraten. Dabei kann unterstützend die gesamte Fläche des Trägers, beispielsweise von einer UV-Quelle, bestrahlt werden. Es ist jedoch auch ein Abziehen des Trägers unter Erwärmung des Substrats möglich.

Zum Aufbringen der Klebstoffschicht auf das Trägermaterial kann ein Sprühprozess vorgesehen werden. Auch ein Aufrollen oder Aufwalzen der Klebstoffschicht auf ein Trägermaterial ist möglich.

Die Lotkugelkontaktelemente können zeilenweise aus parallel nebeneinander angeordneten Spenderdüsen in vorgegebener minimal zulässiger Schrittweite für einen Halbleiterchip oder ein Halbleiterbauteil auf die Klebstoffschicht aufgeklebt werden. Derartige Spenderdüsen können die Form von Pipetten aufweisen, in deren Kapillaren die Lötkugelelemente gestapelt sind. Zur Minderung der Adhäsion der Klebstoffschicht können UV-Strahlen oder Laserstrahlen selektiv an den vorgegebenen Positionen auf den Träger und/oder die Klebstoffschicht einwirken, so dass nur derartige Lotkugelelemente entfernt werden, die nicht zu dem Anordnungsmuster der Kontaktflächen auf einem Substrat passen.

Wie oben bereits erwähnt, kann das Abheben des Trägermaterials von den aufgelöteten Kugelkontakten durch großflächige Bestrahlung des Trägermaterials abgezogen werden.

Zusammenfassend ist festzustellen, dass mit dem Träger der sogenannte "ball apply prozess" bzw. die sogenannte "bumping methode" durch die Verwendung des Trägers wesentlich erleichtert wird, da nun für jedes "ballout" nicht mehr ein eigenes Werkzeug, nämlich ein sogenanntes "tool" anzufertigen ist.

Damit werden auch die Prozesszeiten.verkürzt, insbesondere beim sogenannten "wafer bumping" bzw. "wafer ball apply".

Durch das vollflächige Aufbringen von Lotkugelelementen bzw. sogenannten "balls" auf eine Klebstoffschicht eines Trägers, die so beschaffen ist, dass sie unter Einfluss entsprechender Wärme und/oder Strahlung an den bestrahlten Flächen die Haftkraft verliert, ist es möglich, vorgegebene Anordnungsmuster für die Kugelkontakte von Halbleiterchips, Halbleiterwafern, Halbleiterbauteilen oder auch von Stapelbauteilen präzise und einfach zu realisieren. Im Prinzip lassen sich sämtliche gewünschte "ballouts" realisieren. Ein eventuell für das Auflöten benötigtes Flussmittel kann direkt auf die verbliebenen "balls/bumps" aufgebracht werden. Alternativ kann der Flussmittelauftrag auch auf die Kontaktflächen bzw. "bondpads" aufgebracht werden. Somit liefert der Träger bei der Verwendung der erfindungsgemäßen Anlage zum Bestücken des Trägers und dem Verfahren zum Bestücken von Substraten mit Kugelkontakten, den sogenannten "balls" die nachfolgenden Vorteile:
1. universell einsetzbarer Träger für alle Kugelgrößen;
2. universelle Abbildung verschiedener Kontaktkugelschrittweiten, sogenannter "ball pitches", die auch auf einem einzelnen Träger kombinierbar sind;
3. Verwendung von Endlosbändern ist möglich,
4. Verwendung von Folien ist möglich;
5. prinzipiell ist jedes Anordnungsmuster bzw. jdedes "ballout" realisierbar;
6. eine sehr große Genauigkeit ist durch die Möglichkeit von fotolithografischen Prozessen, beispielsweise beim selektiven Bestrahlen realisierbar;
7. bei großen Flächen wie Oberflächen von Halbleiterwafern ist das Bestücken mit Kugelkontakten, das sogenannte "beballen" durch einen einzigen Prozessschritt möglich;
8. auch ein Auftrag von Flussmittel kann direkt auf die Lotkugelelemente des Trägers erfolgen, ohne dass ein zusätzliches Werkzeug notwendig wäre.

Die Erfindung wird nun anhand der beigefügten Figuren näher erläutert.
- Figur 1: zeigt eine schematische Untersicht auf einen Träger mit Lotkugelelementen gemäß einer ersten Ausfüh- rungsform;
- Figur 2: zeigt eine schematische Untersicht auf einen Träger mit Lotkugelelementen nach Strukturierung des Trä- gers der Figur 1 zu einem Anordnungsmuster der Lot- kugelelemente;
- Figur 3: zeigt einen schematischen Querschnitt eines Trägers durch eine Spalte von Lotkugelelementen;
- Figur 4: zeigt einen Querschnitt einer Anordnung für ein selektives Bestrahlen einer Klebstoffschicht des Trägers;
- Figur 5: zeigt einen schematischen Querschnitt einer Anord- nung für ein selektives Beschichten eines Verdrah- tungssubstrats mit Kugelkontakten;
- Figur 6: zeigt ein großflächiges Bestrahlen des Trägers für ein Trennen von Träger und Lotkontaktelementen;
- Figur 7: zeigt einen schematischen Querschnitt durch ein Halbleiterbauteil mit einem Halbleiterchip in Flip- Chip Technik, wobei sowohl die Flipchip-Kontakte als auch die Außenkontakte des Halbleiterbauteils mit Hilfe von Trägern positioniert sind;
- Figur 8: zeigt einen schematischen Querschnitt durch ein Halbleiterstapelbauteil mit Stapelkontakten, welche die Verbindung zwischen Unterseite und Oberseite des Halbleiterstapelbauteils des Stapels ermögli- chen.

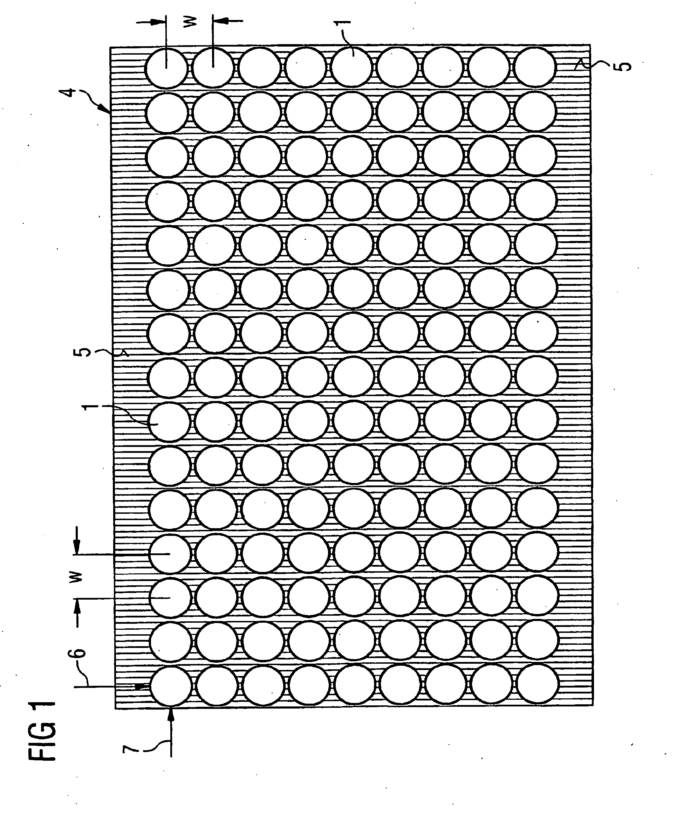

Figur 1 zeigt eine schematische Untersicht auf einen Träger 4 mit Lotkugelelementen 1 gemäß einer ersten Ausführungsform. Auf seiner Unterseite weist der Träger 4 eine Klebstoffschicht 5 auf, die bei Bestrahlungseinwirkung bzw. Wärmeeinwirkung eine verminderte Adhäsion für die auf der Klebstoffschicht 5 angeordneten Lotkugelelemente 1 aufweist. Die Lotkugelelemente 1 sind auf der Klebstoffschicht 5 des Trägers 4 in Zeilen 6 und Spalten 7 in einer Schrittweite w sowohl in Richtung der Zeilen 6 als auch in Richtung der Spalten 7 angeordnet. Der Träger 4 ist als Endlosband ausgebildet, wobei der in Figur 1 gezeigte Abschnitt des Endlosbandes passend für ein Substrat aus gewählt wurde, auf dessen Kontaktflächen an vorbestimmten Positionen Lotkugelelementen 1 zu Kugelkontakten aufgelötet werden sollen.

Ein derartiger Träger 4 kann dadurch hergestellt werden, dass zunächst ein Trägermaterial mit der Klebstoffschicht 5 aus einem Duroplast oder Thermoplast versehen wird und die Lotkugelelemente 1 aus einer Pipettenharfe zeilenweise auf der Klebstoffschicht 5 fixiert werden. Eine derartige Pipettenharfe kann die Lotkugelelemente 1 einer Zeile 6 rechtzeitig über die Kanülen der Pipetten zuführen. Es ist auch möglich, über eine Vakuumpipettenharfe jeweils die Lotkugelelemente 1 einer Zeile 6 an den Mundstücken der Vakuumpipetten zu halten, bis sie auf der Klebstoffschicht 5 des Trägers 4 fixiert sind.

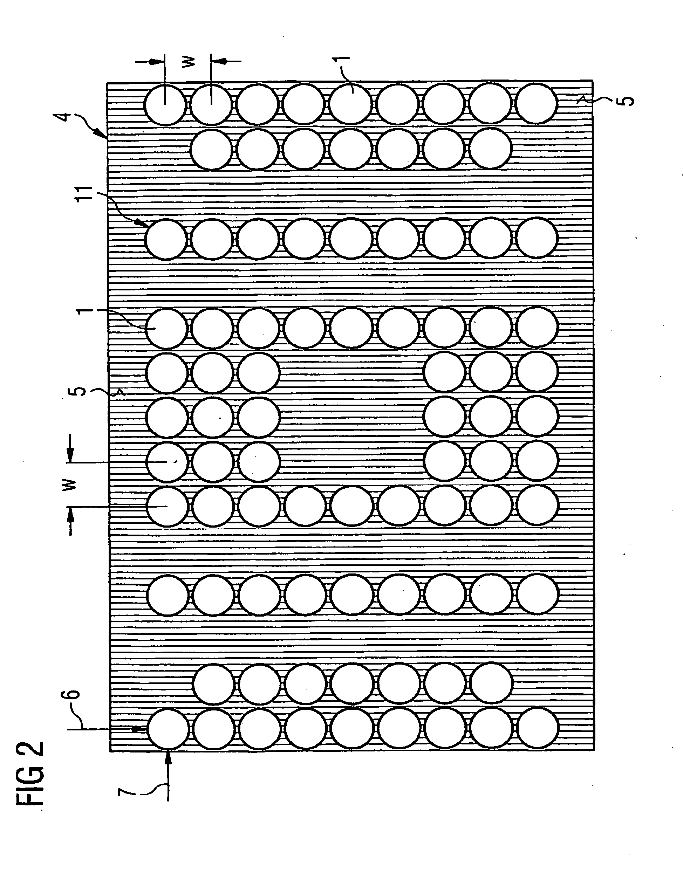

Figur 2 zeigt eine schematische Untersicht auf einen Träger 4 mit Lotkugelelementen 1 nach Strukturierung des Trägers 4, der Figur 1 zu einem Anordnungsmuster 11 der Lotkugelelemente 1. Dieses Anordnungsmuster 11 entspricht einem Kontaktflächenmuster eines Substrats, das mit den in Figur 2 gezeigten Lotkugelelementen 1 bestückt werden soll. Dazu können die Lotkugelelemente 1 dieses Anordnungsmusters 11 zunächst mit einem Flussmittel in Kontakt gebracht werden, das beispielsweise durch einen Stempel oder durch eine Walze auf die Lotkugelelemente 1 aufgetragen wird.

Mit den nachfolgenden Figuren wird erläutert, wie ein derartiges Anordnungsmuster 11 herstellbar ist und wie anschließend dieses Muster von Lotkugelelementen auf Kontaktflächen eines Substrats zu Kugelkontakten aufgelötet wird. Die in Figur 2 und den nachfolgenden Figuren gezeigten Bezugszeichen werden nicht mehr erläutert, wenn die Komponenten dieser Bezugszeichen die gleichen Funktionen wie in Figur 1 erfüllen.

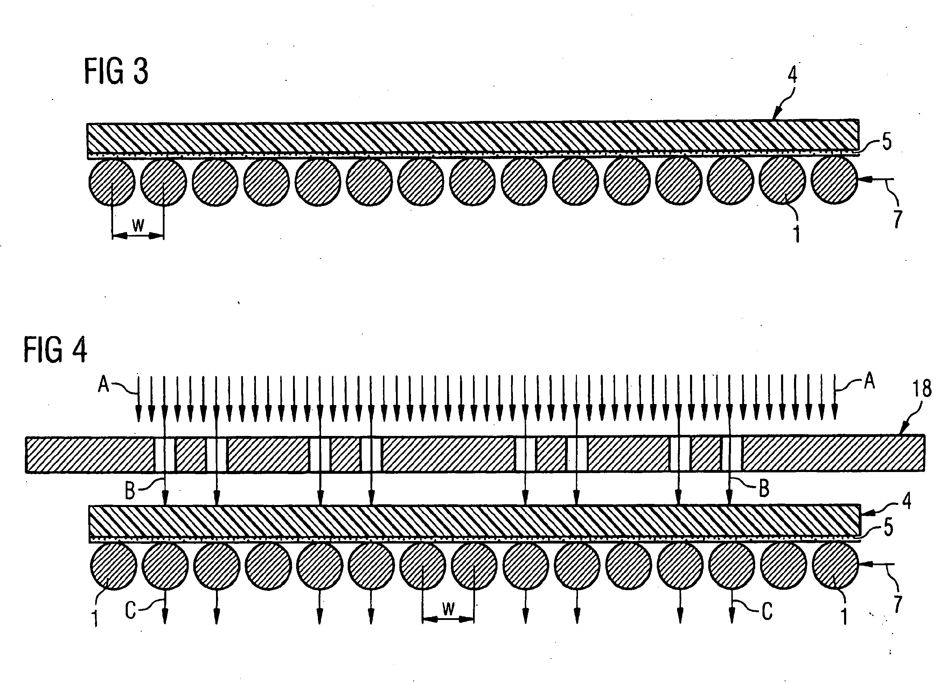

Figur 3 zeigt einen schematischen Querschnitt eines Trägers 4 durch eine Spalte 7 von Lotkugelelementen 1. Jede mögliche Position ist in einer Schrittweite w bei diesem Träger 4 mit einem Lotkugelelement 1 belegt, so dass die Spalte 7 zunächst vollständig mit Lotkugelelementen 1 besetzt ist, wobei die Klebstoffschicht 5 dafür sorgt, dass die Lotkugelelemente 1 in ihrer Position fixiert sind.

Figur 4 zeigt einen Querschnitt einer Anordnung für ein selektives Bestrahlen einer Klebstoffschicht 5 des Trägers 4. In diesem Fall erfolgt die Bestrahlung durch eine großflächige UV-Strahlungsquelle die in Pfeilrichtungen A eine Maske 18 einer Anlage zum Bestücken von Substraten mit Kugelkontakten bestraht. Diese Maske 18 bestrahlt in Pfeilrichtung B nur die Positionen der Lotkugelelemente 1 des Trägers 4, die von dem Träger 4 in Pfeilrichtung C entfernt werden sollen. Die übrigen Lotkugelelemente 1 werden durch die Maske 18 vor einem Bestrahlen mit UV-Licht geschützt. Somit verbleiben nach dem Ende dieses Prozesses die Lotkugelelemente auf der Klebstoffschicht 5, deren Position nicht von den UV-Strahlen A getroffen wurden. Eine derartige Maske 18 kann mit Hilfe der Fotolithographie präzise vorbereitet werden, so dass ein exaktes Anordnungsmuster von Lotkugelelementen 1 auf dem Träger 4 nach diesem Schritt zurückbleibt.

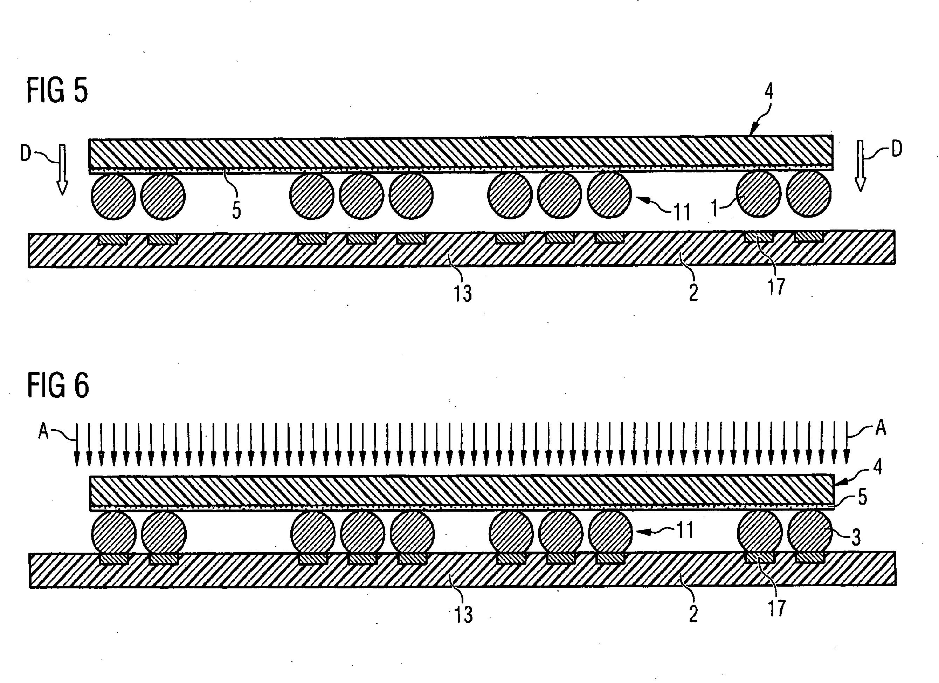

Figur 5 zeigt einen schematischen Querschnitt eines Anordnung für ein selektives Beschichten eines Verdrahtungssubstrats 2 mit Kugelkontakten. Dazu wird das Anordnungsmuster 11 aus Lotkugelelementen 1 des Trägers 4 gegenüber dem Verdrahtungssubstrat 2 solange ausgerichtet, bis die Lotkugelelemente 1 den Kontaktflächen 17 des Verdrahtungssubstrats 2 gegenüberliegen. Dann wird in Pfeilrichtung D der Träger 4 mit seinem Anordnungsmuster 11 aus Lotkugelelementen 1 auf das Verdrahtungssubstrat 2 verbracht und in einem Lötprozess wird ein Auflöten der Lotkugelelemente 1 zu Kontaktkugeln auf dem Verdrahtungssubstrat 2 in den Positionen der Kontaktflächen 17 durchgeführt. Der Träger 4 mit seiner Klebstoffschicht 5 ist nun noch auf den Kugelkontakten vorhanden und muss, wie es Figur 6 zeigt, entfernt werden.

Figur 6 zeigt ein großflächiges Bestrahlen des Trägers 4 für ein Trennen von Träger 4 und Kugelkontakten 3 des Verdrahtungssubstrats 2. Komponenten mit gleichen Funktionen, wie in den vorhergehenden Figuren, werden mit gleichen Bezugszeichen gekennzeichnet und nicht extra erörtert. Das großflächige Bestrahlen beispielsweise mit einer UV-Quelle wird wieder durch die Pfeile A verdeutlicht, wobei diesmal keine Maske erforderlich ist, zumal sämtliche verbliebene bisher noch nicht bestrahlte Positionen der Klebstoffschicht 5 sich nun von den ursprünglichen Lotkugelelementen lösen sollen.

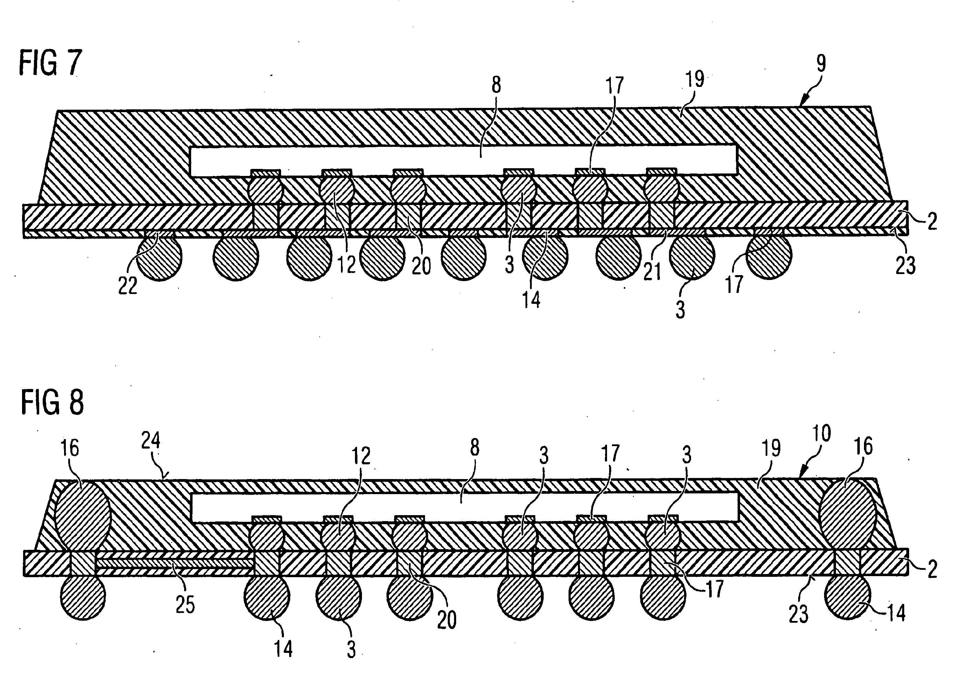

Figur 7 zeigt einen schematischen Querschnitt durch ein Halbleiterbauteil 9 mit einem Halbleiterchip 8 in Flip-Chip Technik, wobei sowohl die Flipchip-Kontakte 12 des Halbleiterchips 8 als auch die Außenkontakte 14 des Halbleiterbauteils 9 mit Hilfe von erfindungsgemäßen Trägern 4 positioniert wurden. Die Darstellung in Figur 7 ist nicht maßstabsgerecht, zumal die Außenkontakte 14 auf der Unterseite 23 des Verdrahtungssubstrats 2 etwa um eine Größenordnung, größere Außendimensionen aufweisen als die Flipchip-Kontakte 12 auf den Kontaktflächen 17 des Halbleiterchips 8. Der Halbleiterchip 8 ist mit seinen Flipchip-Kontakten 12 von einer Kunststoffmasse 19 in dieser Ausführungsform der Erfindung umgeben, die gleichzeitig einen oberen Teil des Gehäuses dieses Halbleiterbauteils 9 bildet.

Die Unterseite des Gehäuses wird im wesentlichen von dem Verdrahtungssubstrat 2 gebildet, auf dem nach außen die Außenkontakte 14 gleichförmig verteilt angeordnet sind, während die Flipchip-Kontakte 12 sich nach der Position der Kontaktflächen 17 des Halbleiterchips 8 richten. Um dennoch die Flipchip-Kontakte 12 elektrisch mit den Außenkontakten 14 zu verbinden, weist das Verdrahtungssubstrat 2 Durchkontakte 20 auf, die durch das Verdrahtungssubstrat 2 erstrecken und über eine Verdrahtungsstruktur 21 mit Außenkontaktflächen 22 auf der Unterseite 23 des Verdrahtungssubstrats 2 verbunden sind. Auf diesen Außenkontaktflächen 22 sind mit der oben beschriebenen Technik mit Hilfe eines Trägers die Außenkontakte 14 angeordnet.

Figur 8 zeigt einen schematischen Querschnitt durch ein Halbleiterstapelbauteil 10 mit Stapelkontakten 16, welche die Verbindung zwischen der Unterseite 23 und der Oberseite 24 des Halbleiterstapelbauteils 10 ermöglichen. Die Ausführungsform gemäß Figur 8 unterscheidet sich von den vorhergehenden Ausführungsformen dadurch, dass drei völlig unterschiedliche Lotkugelgrößen für die Herstellung dieses Halbleiterbauteils 10 verarbeitet werden und dementsprechend auch drei unterschiedlich strukturierte Träger mit Lotkugelelementen für die Fertigung dieses Halbleiterbauteils 10 zur Verfügung stehen.

Bei den Stapelkontakten 16 kommt es darauf an, dass die gesamte Kunststoffmasse 19, die den oberen Teil des Gehäuses des Halbleiterstapelbauteils 10 bildet, von dem Stapelkontakten 16 durchdrungen wird. Dazu sind sie in Randbereichen des Verdrahtungssubstrats 2 rund um den Halbleiterchip 8 angeordnet. Entsprechende Umverdrahtungsleitungen 25 stellen sicher, dass die Außenkontakte 14 und die Stapelkontakte 16 elektrisch miteinander verbunden sind. Über die Durchkontakte 20 sind zusätzlich die Flipchip-Kontakte 12 des Halbleiterchips 8 mit den Außenkontakten 14 verbunden. Somit ist es möglich, eine Vielzahl dieser Halbleiterstapelbauteile 10 übereinander anzuordnen und über die Stapelkontakte 16 mit den Außenkontakten 14 des Halbleiterbauteilstapels 10 zu verbinden.

## Patentansprüche

1. Anlage für ein Bestücken von Substraten (2) mit Kugelkontakten (3), wobei die Vorrichtung folgende Merkmale aufweist
- einen Träger (4) mit einseitiger Klebstoffschicht (5), wobei die Klebstoffschicht (5) einen Thermoplast oder Duroplast aufweist, dessen Adhäsionskraft bei Bestrahlung vermindert ist;
- Lotkugelelemente (1), die dichtgepackt in Zeilen (6) und Spalten (7) auf der Klebstoffschicht (5) in vorgegebener minimalzulässiger Schrittweite (w) für einen Halbleiterchip (8) oder ein Halbleiterbauteil (9) angeordnet sind;
- eine Bestrahlungseinrichtung mit einer Strahlungsquelle und Vorrichtungen zum selektiven Bestrahlen des Trägers (4) zur Minderung der Adhäsion der Klebstoffschicht (5) zur Lockerung von Lotkugelelementen (1) an vorgegebenen Positionen;
- eine Abnahmeeinrichtung zum Entfernen der gelockerten Lotkugelelemente (1) und Zurücklassung von Lotkugelelementen (1) in einem Anordnungsmuster (11) für Flipchip-Kontakte (12) oder Kugelkontakte (3);
- Bestückungseinrichtung zum Fixieren der in einem vorgegebnen Anordnungsmuster (11) auf dem Träger (4) verbliebenen Lotkugelelemente (1) auf Kontaktflächen (17) des Halbleiterwafers oder Halbleiterchips (8) oder des Verdrahtungsträgers für Halbleiterbauteile (9);
- Abzugseinrichtung zum Abziehen des Trägers (4) von den Kugelkontakten (3).

2. Anlage nach Anspruch 1,
**dadurch gekennzeichnet, dass**
die Bestrahlungseinrichtung eine Laserstrahlquelle aufweist und Ablenkvorrichtungen zum Scannen des Laserstrahls zum selektiven Bestrahlen des Trägers (4) an vorgegebenen Positionen umfasst.

3. Anlage nach Anspruch 1,
**dadurch gekennzeichnet, dass**
die Bestrahlungseinrichtung eine UV-Quelle aufweist und zum selektiven Bestrahlen des Trägers (4) mit UV-Strahlen einen Maskenhalter mit Masken (18) für eine UV-Bestrahlung des Trägers (4) an vorgegebenen Positionen aufweist.

4. Anlage nach einem der Ansprüche 1 bis 3,
**dadurch gekennzeichnet, dass**
die Abnahmeeinrichtung zum Entfernen der gelockerten Lotkugelelemente (1) eine Walze oder eine Endlosband aufweist, welche mit klebrigen Oberflächen versehen sind, an denen gelockerte Lotkugelelemente (1) haften bleiben.

5. Anlage nach einem der Ansprüche 1 bis 4,
**dadurch gekennzeichnet, dass**
die Abnahmeeinrichtung zum Entfernen der gelockerten Lotkugelelemente (1) eine Walze oder ein Endlosband aufweist, auf deren Oberseiten Abstreifborsten vorgesehen sind.

6. Anlage nach einem der Ansprüche 1 bis 5,
**dadurch gekennzeichnet, dass**
die Bestückungseinrichtung eine Halterung für zu bestückende Substrate (2) und eine Trägerhalterung für den Träger (4) mit einem Anordnungsmuster (11) aus Lotkugelelementen (1), sowie Justagemittel zum Ausrichten der verbliebenen Lotkugelelemente (1) des Trägers (4) in der Trägerhalterung auf Kontaktflächen (17) der zu bestückenden Substrate (2) der Halterung aufweist.

7. Verfahren für ein Bestücken von Substraten (2) mit Kugelkontakten (3), das folgende Verfahrensschritte aufweist:
- Herstellen eines Bandes aus Trägermaterial mit einseitiger Klebstoffschicht (5), die einen Thermoplast oder Duroplast aufweist, dessen Adhäsionskraft bei Bestrahlung vermindert ist;
- Anordnen von Lotkugelelementen (1) in Zeilen (6) und Spalten (7) auf der Klebstoffschicht (5) in vorgegebener minimalzulässiger Schrittweite (w) für einen Halbleiterchip (8) oder für ein Halbleiterbauteil (9);
- selektives Bestrahlen des Trägers (4) zur Minderung der Adhäsion der Klebstoffschicht (5) und zur Lockerung von Lotkugelelementen (1) an vorgegebenen Positionen;
- Entfernen der gelockerten Lotkugelelemente (1) und Zurücklassen von auf dem Träger (4) fixierten Lotkugelelementen (1) in einem Anordnungsmuster (11) für einen Halbleiterchip (8) oder für ein Halbleiterbauteil (9);
- Auflöten der in einem vorgegebenen Anordnungsmuster (11) auf dem Träger (4) verbliebenen Lotkugelelemente (1) auf Kontaktflächen (17) eines Halbleiterwafers oder Halbleiterchips (8) oder Verdrahtungsträgers für Halbleiterbauteile (9);
- Abziehen des Trägers (4) von den mit Flipchip-Kontakten (12) oder Kugelkontakten (3) zu bestückenden Substrat (2).

8. Verfahren nach Anspruch 7,
**dadurch gekennzeichnet, dass**
der Träger (4) einseitig mit einer Klebstoffschicht (5) besprüht wird.

9. Verfahren nach Anspruch 7 oder Anspruch 8,
**dadurch gekennzeichnet, dass**
die Lotkugelelemente (1) zeilenweise aus parallel nebeneinander angeordneten Spenderdüsen in vorgegebener minimalzulässiger Schrittweite (w) für einen Halbleiterchip (8) oder ein Halbleiterbauteil (9) auf die Klebstoffschicht (5) aufgeklebt werden.

10. Verfahren nach einem der Ansprüche 7 bis 9,
**dadurch gekennzeichnet, dass**
ein Laserstrahl zum selektives Bestrahlen des Trägers (4) zur Minderung der Adhäsion der Klebstoffschicht (5) und zur Lockerung von Lotkugelelementen (1) an vorgegebenen Positionen über den Träger (4) geführt wird.

11. Verfahren nach einem der Ansprüche 7 bis 10,
**dadurch gekennzeichnet, dass**
der Träger (4) selektiv durch eine Maske (18) mit UV-Strahlen zur Minderung der Adhäsion der Klebstoffschicht (5) und zur Lockerung von Lotkugelelementen (1) an vorgegebenen Positionen bestrahlt wird.

12. Verfahren nach einem der Ansprüche 7 bis 11,
**dadurch gekennzeichnet** Anlage, **dass**
der Träger (4) einer großflächigen Bestrahlung ausgesetzt, und der Träger (4) von den Kugelkontakten (3) abgezogen wird.

## Claims

1. A system for loading substrates (2) with ball contacts (3), the system comprising the following features:
- a support (4) with a layer of adhesive (5) on one side, the layer of adhesive comprising a thermoplastic or thermosetting material, the adhesive force of which is reduced when irradiated;
- solder ball elements (1) which are arranged closely packed in rows (6) and columns (7) on the layer of adhesive (5) in a prescribed minimally permissible pitch (w) for a semiconductor chip (8) or a semiconductor component (9) and,
- an irradiating device with a source of radiation and apparatus for selectively irradiating the support (4) to reduce the adhesion of the layer of adhesive (5) for loosening solder ball elements (1) at prescribed positions;
- a removal device for removing the loosened solder ball elements (1) and leaving solder ball elements (1) in an arrangement pattern (11) for flip-chip contacts (12) or ball contacts (3);
- a loading device for fixing the solder ball elements (1) remaining on the support (4) in a prescribed arrangement pattern (11) on contact areas (17) of the semiconductor wafer or semiconductor chip (8) or the wiring support for semiconductor components (9);
- a pulling-off device for pulling the support (4) off the ball contacts (3).

2. The system according to claim 1, **characterized in that** the irradiating device comprises a laser beam source and comprises deflecting devices for scanning the laser beam for selectively irradiating the support (4) at prescribed positions.

3. The system according to claim 1, **characterized in that** the irradiating device comprises a UV source and, for selectively irradiating the support (4) with UV rays, a mask holder with masks (18) for UV irradiation of the support (4) at prescribed positions.

4. The system according to one of claims 1 to 3, **characterized in that** the removal device for removing the loosened solder ball elements (1) comprises a roller or a continuous tape, which are provided with tacky surfaces on which loosened solder ball elements (1) remain adhesively attached.

5. The system according to one of claims 1 to 4, **characterized in that** the removal device for removing the loosened solder ball elements (1) comprises a roller or a continuous tape on the upper sides of which stripping bristles are provided.

6. The system according to one of claims 1 to 5, **characterized in that** the loading device comprises a holder for substrates (2) to be loaded and a support holder for the support (4) with an arrangement pattern (11) of solder ball elements (1), as well as adjusting means for aligning the remaining solder ball elements (1) of the support (4) in the support holder with contact areas (17) of the substrates (2) to be loaded of the holder.

7. A method for loading substrates (2) with ball contacts (3), which comprises the following method steps:
- producing a tape from support material with a layer of adhesive (5) on one side, comprising a thermoplastic or thermosetting material, the adhesive force of which is reduced when irradiated;
- arranging solder ball elements (1) in rows (6) and columns (7) on the layer of adhesive (5) in a prescribed minimally permissible pitch (w) for a semiconductor chip (8) or for a semiconductor component (9);
- selectively irradiating the support (4) to reduce the adhesion of the layer of adhesive (5) and loosen solder ball elements (1) at prescribed positions;
- removing the loosened solder ball elements (1) and leaving solder ball elements (1) that are fixed on the support (4) in an arrangement pattern (11) for a semiconductor chip (8) or for a semiconductor component (9);
- soldering the solder ball elements (1) remaining in a predetermined arrangement pattern (11) on the support (4) onto contact areas (17) of a semiconductor wafer or semiconductor chip (8) or wiring support for semiconductor components (9);
- pulling the support (4) off the substrate (2) to be loaded with flip-chip contacts (12) or ball contacts (3).

8. The method according to claim 7, **characterized in that** the support (4) is sprayed on one side with a layer of adhesive (5).

9. The method according to claim 7 or claim 8, **characterized in that** the solder ball elements (1) are adhesively attached onto the layer of adhesive (5) in rows, from dispensing nozzles arranged in parallel next to one another, in a prescribed minimally permissible pitch (w) for a semiconductor chip (8) or a semiconductor component (9).

10. The method according to one of claims 7 to 9, **characterized in that** a laser beam for selectively irradiating the support (4) to reduce the adhesion of the layer of adhesive (5) and to loosen solder ball elements (1) at prescribed positions is passed over the support (4).

11. The method according to one of claims 7 to 10, **characterized in that** the support (4) is selectively irradiated with UV rays through a mask (18) to reduce the adhesion of the layer of adhesive (5) and to loosen solder ball elements (1) at prescribed positions.

12. The method according to one of claims 7 to 11, **characterized in that** the support (4) is subjected to irradiation over a large surface area, and the support (4) is pulled off the ball contacts (3).

## Revendications

1. Installation pour équipe des substrats (2) avec des contacts sphériques (3), le dispositif présentant les caractéristiques suivantes :
- un support (4) comportant une couche d'adhésif (5) sur une face, la couche d'adhésif (5) présentant un thermoplastique ou un plastique thermodurcissable dont la force d'adhérence sous irradiation est réduite,
- des éléments sphériques de soudure (1) qui sont disposés de manière compacte en lignes (6) et en colonnes (7) sur la couche d'adhésif (5), à un pas (w) minimal admissible prédéterminé, pour une puce semi-conductrice (8) ou un composant semi-conducteur (9),
- un dispositif d'irradiation comportant une source de rayonnement et des dispositifs d'irradiation sélective du support (4) en vue de diminuer l'adhérence de la couche d'adhésif (5) pour relâcher des éléments sphériques de soudure (1) en des positions prédéterminées,
- un dispositif d'enlèvement qui enlève les éléments sphériques de soudure (1) relâchés et laisse des éléments sphériques de soudure (1) selon un motif d'agencement (11) pour des contacts "flipchip" (12) ou des contacts sphériques (3),
- un dispositif d'équipement qui fixe sur des surfaces de contact (17) de la galette semi-conductrice, de la puce semi-conductrice (8) ou du support de câblage pour composants semi-conducteurs (9) les éléments sphériques de soudure (1) qui restent sur le support (4) selon un motif d'agencement (11) prédéterminé, détache
- un dispositif de détachement qui enlève le support (4) des contacts sphériques (3).

2. Installation selon la revendication 1, **caractérisée en ce que** le dispositif d'irradiation présente une source de rayonnement laser et des dispositifs de déviation qui permettent de déplacer le faisceau laser de telle sorte qu'il irradie sélectivement le support (4) en des positions prédéterminées.

3. Installation selon la revendication 1, **caractérisée en ce que** le dispositif d'irradiation comprend une source d'UV et présente un porte-masques comportent des masques (18) qui permettent d'irradier le support (4) par des UV en des positions prédéterminées pour l'irradiation sélective du support (4) par des rayons UV.

4. Installation selon l'une des revendications 1 à 3, **caractérisée en ce que** le dispositif d'enlèvement qui enlève les éléments sphériques de soudure (1) relâchés présente un cylindre ou une bande sans fin qui comportent des surfaces adhésives sur lesquelles des éléments sphériques de soudure (1) relâchés restent adhérer.

5. Installation selon l'une des revendications 1 à 4, **caractérisée en ce que** le dispositif d'enlèvement qui enlève les éléments sphériques de soudure (1) relâchés présente un cylindre ou une bande sans fin sur le côté supérieur desquels des brosses de raclage sont prévues.

6. Installation selon l'une des revendications 1 à 5, **caractérisée en ce que** le dispositif d'équipement présente un support pour des substrats (2) à équiper et un dispositif de retenue de support pour le support (4), lequel dispositif de retenue présente un motif d'agencement (11) d'éléments sphériques de soudure (1), ainsi que des moyens d'ajustement qui alignent les éléments sphériques de soudure (1) qui restent sur le support (4) situé dans le dispositif de retenue du support sur des surfaces de contact (17) des substrats (2) à équiper du support.

7. Procédé pour équiper des substrats (2) avec des contacts sphériques (3), lequel procédé présente les étapes suivantes :
- préparation d'une bande de matériau de support comportent une couche d'adhésif (5) sur une face la couche d'adhésif (5) présentant un thermoplastique ou un plastique thermodurcissable dont la force d'adhérence sous irradiation est réduite,
- agencement d'éléments sphériques de soudure (1) en lignes (6) et en colonnes (7) sur la couche d'adhésif (5) à un pas (w) minimal admissible prédéterminé pour une puce semi-conductrice (8) ou un composant semi-conducteur (9),
- irradiation sélective du support (4) pour diminuer l'adhérence de la couche d'adhésif (5) et pour relâcher des éléments sphériques de soudure (1) en des positions prédéterminées,
- enlèvement des éléments sphériques de soudure (1) relâchés et maintien des éléments sphériques de soudure (1) fixés sur le support (4) selon un motif d'agencement (11) pour une puce semi-conductrice (8) ou pour un composant semi-conducteur (9),
- soudage des éléments sphériques de soudage (1) qui restent sur le support (4) selon un motif d'agencement (11) prédéterminé sur des surfaces de contact (17) d'une galette semi-conductrice, d'une puce semi-conductrice (8) ou d'un support de câblage pour composants semi-conducteurs (9),
- détachement du support (4) du substrat (2) qui doit être équipé de contacts "flipchip" (12) ou de contacts sphériques (3).

8. Procédé selon la revendication 7, **caractérisé en ce qu'**une couche d'adhésif (5) est pulvérisée sur une face du support (4).

9. Procédé selon la revendication 7 ou la revendication 8, **caractérisé en ce que** les éléments sphériques de soudure (1) provenant de tuyères de distribution disposées parallèlement les unes aux autres sont collés en lignes sur la couche d'adhésif (5) à un pas (w) minimal admissible prédéterminé pour une puce semi-conductrice (8) ou un composant semi-conducteur (9).

10. Procédé selon l'une des revendications 7 à 9, **caractérisé en ce qu'**un faisceau laser est guidé en des positions prédéterminées au-dessus du support (4) pour irradier sélectivement le support (4) en vue de diminuer l'adhérence de la couche d'adhésif (5) et de relâcher des éléments sphériques de soudure (1).

11. Procédé selon l'une des revendications 7 à 10, **caractérisé en ce que** le support (4) est irradié sélectivement à travers un masque (18) par un rayonnement UV en des positions prédéterminées en vue de diminuer l'adhérence de la couche d'adhésif (5) et de relâcher des éléments sphériques de soudure (1).

12. Procédé selon l'une des revendications 7 à 11, **caractérisé en ce que** le support (4) est exposé à une irradiation de grande surface et le support (4) est retiré des contacts sphériques (3).
